Europäisches Patentamt

(19) European Patent Office

Office européen des brevets

(11) Publication number : **0 321 576 B1**

(12) **EUROPEAN PATENT SPECIFICATION**

(45) Date of publication of patent specification :
25.11.92 Bulletin 92/48

(51) Int. Cl.⁵ : **C30B 11/00**

(21) Application number : **88905239.5**

(22) Date of filing : **14.06.88**

(86) International application number :
**PCT/JP88/00572**

(87) International publication number :
**WO 88/10329 29.12.88 Gazette 88/28**

(54) **METHOD FOR GROWING SINGLE CRYSTAL FROM MOLTEN LIQUID.**

(30) Priority : **15.06.87 JP 146939/87**

(43) Date of publication of application :
**28.06.89 Bulletin 89/26**

(45) Publication of the grant of the patent :
**25.11.92 Bulletin 92/48**

(84) Designated Contracting States :
**DE FR GB IT**

(56) References cited :
**DE-A- 1 138 514**
**GB-A- 923 241**
**JP-A-58 104 100**
**JP-U-58 148 071**

(56) References cited :
**PATENT ABSTRACTS OF JAPAN, vol. 8, no. 15 (C-206)[1452], 21 January 1984**
**PATENT ABSTRACTS OF JAPAN, vol. 10, no. 28 (C-326)[2085], 04 February 1986**
**PATENT ABSTRACTS OF JAPAN, vol. 11, no. 141 (C-421)[2588], 08 May 1987**

(73) Proprietor : **MITSUI MINING COMPANY, LIMITED**
**1-1, Nihonbashi-Muromachi 2-chome**
**Chuo-ku Tokyo 103 (JP)**

(72) Inventor : **OMINO, Akira**
**1-2-301, Kunimi 1-chome**
**Sendai-shi Miyagi 980 (JP)**

(74) Representative : **Baverstock, Michael George Douglas et al**
**BOULT, WADE & TENNANT 27 Furnival Street**
**London, EC4A 1PQ (GB)**

## Description

## Technical Field

The present invention relates to a method for obtaining single crystals by solidification, crystal growth out of a melt.

## Background Art

In recent years, the technique of crystal growth has become industrially very important with the development of the electronic industry and the like. Moreover, much attention is now paid to compound materials such as GaAs, CdS and ZnSe as new functional elements in addition to simple substances such as Si and Ge. For the preparation of single crystals of these materials, there is a method of solidifying them out of a melt. This method is widely utilized to grow single crystals, since it can provide large crystals relatively easily.

However, when the vapor pressure of the compound melt is high, a good deal of the compound is vaporized from a crucible and thus it is difficult to prepare crystals from the compound. Furthermore, if one component in a compound has a high volatilization rate, the composition of its melt deviates from stoichiometry and normal crystal growth cannot be achieved, with the result that the quality of the prepared crystals is poor.

In general, in order to avoid these problems, a compound is first placed in a quartz ampoule and the latter is then sealed, or alternatively the compound is put in a quartz ampoule having a high-frequency susceptor therein or in a graphite crucible which can function as the susceptor by itself, and the compound is then heated by means of a high-frequency coil disposed outside the quartz ampoule. However, quartz begins to soften at about 1,200°C, and when the temperature further rises, the quartz ampoule is deformed and devitrified. In the worst case, the ampoule may explode. In consequence, the applicable range of the method using the quartz ampoule is limited to compound melts having a temperature of at most 1,400°C.

For a high-melting compound having a melting point of 1,400°C or more, the so-called high-pressure melting process has been heretofore used which comprises placing the compound in a crucible of graphite or the like, putting the crucible in a high-pressure container, and performing crystal growth, while the vaporisation of the compound is inhibit under the pressure of an inactive gas such as argon.

In this process, however, the crucible is not sealed hermetically, and therefore the vaporization of the melt and the deviation of the melt composition from stoichiometry cannot be prevented substantially. In addition, this process has some drawbacks. For example, the materials of the high-pressure container and heater are corroded, and the desired crystals are additionally contaminated with these corroded materials. Furthermore, for a compound having a melting point of 1,400°C or more, there can be a method for growing crystal which comprise charging a high-melting metal crucible with a raw material, melting/sealing the crucible, and heating it. In this method, however, the produced crystals are difficult to release from the crucible, and corrosion is liable to occur in a contact portion of the melt and the metal, and the crystals tend to be contaminated with the metal. In consequence, the above method has such disadvantages as described above and hence it is not considered to be practical.

## Disclosure of the Invention

The present invention provides a method for growing crystals from a hermetically confined raw material even in a temperature range in which quartz ampoules cannot be used.

The present invention is directed to a method for growing single crystals from a melt which comprises the steps of preparing a double structure crucible comprising an outer tube made of a weldable metal or alloy with a melting point of 1500°C or more and an inner tube made of one or more materials selected from metals and alloys with a melting point of 1500°C or more, ceramic materials with a melting point of 1500°C or more and carbon materials such as graphite; placing a raw material in the inner tube and then closing that tube; hermetically sealing the outer tube with an outer lid by welding; and then heating the raw material to melt it and to perform crystal growth.

The first feature of the present invention is as follows: The crucible is constituted of the outer and inner tubes in the form of the double structure, the inner tube is made preferably of graphite or ceramic which has the properties of being hard to corrode while easily releasing the produced crystals, and the outer tube is made of metal which has the property of being easy to seal up. This first feature permits the employment of a carbon material such as graphite and a ceramic material such as BN which have excellent characteristics as the material of the crucible. It should be noted that the above-mentioned carbon material and ceramic material have been difficult to weld and have not been thus used as a container for crystallizing the melt in a hermetical state. That is, the first feature of the present invention enables the establishment of the industrially advantageous method for growing single crystals.

The second feature of the present invention is based on the double structure of the crucible. That is, when crystals adhere to the crucible, which often occurs, the inner tube only need be discarded and the outer tube can be repeatedly used.

The method of the present invention can be applied to the single crystal growth of various raw materials which can provide crystals from their melts, and it can grow the crystals particularly without changing the stoichiometric ratio of the compound having a high melting point and a high vapor pressure. The method of the present case is preferably applicable to the crystal growth of ZnS, ZnSe, CdS, CdSe, GaP, GaAs, CdTe, HgS, PbS, PbSe, InP and the like.

The method of the present invention can exert the following effects and therefore is very beneficial in an industrial field:

(1) Even raw materials having a high melting point and a high vapor pressure can be crystallized, while hermetically confined in the container.

(2) The expensive crucible can be repeatedly used, and the crystal growth can be performed in a relatively inexpensive and ordinary furnace such as a vacuum furnace or an inactive gas furnace. Therefore, the method of the present invention is economical and advantageous.

Brief Description of Drawings

Fig. 1 is a vertical section illustrating one embodiment of a crucible used in the present invention.

Fig. 2 is a vertical section illustrating another embodiment of the present invention.

Fig. 3 is a vertical section illustrating a conventional tungsten crucible used in a comparative example.

Best Mode for Carrying out the Invention

In one method of the present invention, there is used a double structure crucible constituted of an outer tube with a lid and an inner tube with a lid. The material for the outer tube is selected from metals and alloys which have melting points of 1,500°C or more and which are excellent in anticorrosion. Typical examples of these materials include metals such as W, Ta, Os, Mo, Ir, Ru, Rh and Pt as well as alloys based on these metals. Above all, W is the most preferable, because it has a high melting point and a low vapor pressure even at high temperatures and hence it scarcely contaminates the melt.

One end of the outer tube is closed, and the other free end thereof is adapted so as to be covered with a lid made of the same material as that of the outer tube. The cross-sectional shape of the outer tube is not particularly limited, but it is preferably a concentric circle from the viewpoint of heat transfer.

The material of the inner tube is selected from the above-mentioned metals and alloys for the outer tube; carbon materials such as graphite; ceramic materials such as quartz, carbon-coated quartz, alumina, BN, AlN, BeO, MgO, SiC, SiO, $CeO_2$, $ThO_2$, $ZrO_2$ and $ZrSiO_4$. The inner lid is preferably made of the same material is that of the inner tube.

Above all, graphite and BN are particularly preferable, since they are difficult to wet with a raw material melt and therefore formed crystals can be easily released from the inner tube. The outer shape of the inner tube is adapted so that the inner tube may be inserted into the outer tube to form a good fit and the interior of the inner tube can be optionally shaped in compliance with the desired shape of the crystals. In this case, for the easy release of the crystals from the inner tube, the interior of the inner tube is preferably tapered so as to become thin toward the bottom thereof.

The inner tube may be made of a material having relatively weak strength and may have a thin wall thickness, since the strength required for the inner tube is not so severe as in the case of the outer tube.

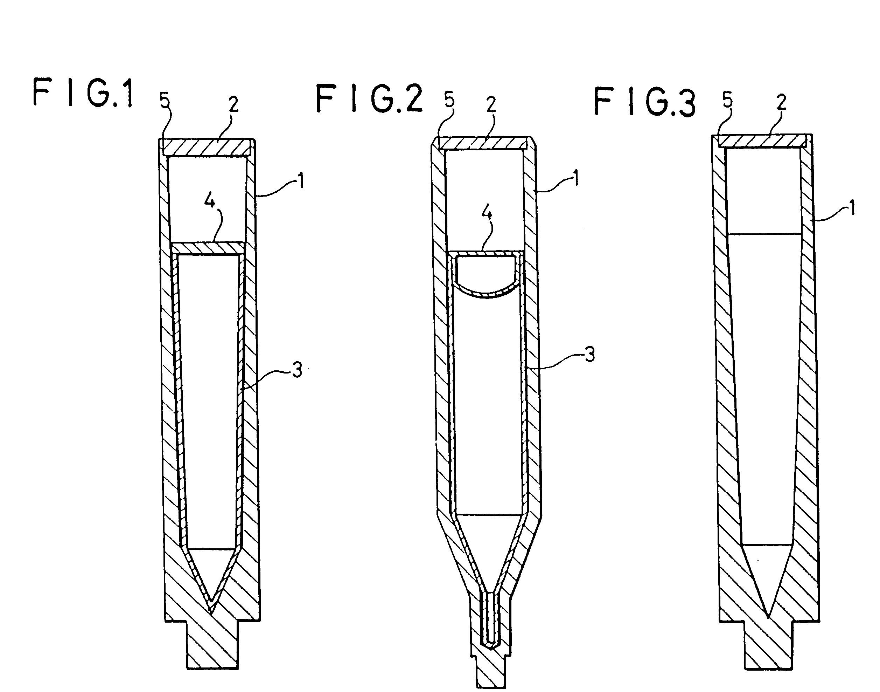

Now, reference to a method for growing the crystals according to the present invention will be made in detail with regard to an embodiment using a crucible shown in Fig. 1. As the materials of the outer and inner tubes, those which do not react with a raw material melt should be suitably selected from the above-mentioned examples. As described above, it is most general to use W as the material for the outer tube and graphite or BM as the material for the inner tube.

It is preferred that the respective parts are cleaned beforehand by burning and the like prior to charging them with a raw material.

In the first place, an inner tube 3 is charged with a raw material for crystals. The raw material may be used in its initial powder state, but preferably it is used after its density is increased by pressing or sintering. The inner tube which has been charged with the raw material is inserted into an outer tube 1, and the inner tube 3 is closed with an inner lid 4 made of the same material as that of the inner tube 3. Afterward, the outer tube 1 is closed with an outer lid 2 made of the same material as that of the outer tube 1, and welding is carried out at a weld portion 5 so as to hermetically seal the outer tube 1 with the outer lid 2 in vacuo or an inactive gas atmosphere under atmospheric pressure or an applied pressure. When the sealing is made in vacuo, the procedure is as follows: The crucible is put in a vacuum device, and the outer lid is then welded to the outer tube by means of electron beams, laser beams or the like, while all of the crucible except the upper portion thereof is cooled by the use of, for example, a water cooling block in order to cool the whole crucible except the weld portion 5 and to thereby perfectly inhibit the raw material from evaporating at the time of the welding. The electron beam welding is usually carried out in vacuo, but in the case of using a laser beam, the welding can be also possible in an inactive gas atmosphere. Therefore, when crystal growth in the inactive gas atmosphere is desired, the crucible can be filled with an inactive gas.

The raw material received in the metallic outer tube is crystallized in an inactive gas furnace or a vacuum furnace in accordance with a conventional manner such as the Bridgman's method.

After the step of the crystal growth, the crucible is cooled, and the upper portion thereof is cut off and the formed crystals are then taken out therefrom. If the outer tube is constituted so as to have a sufficiently long upper portion, the outer tube can be repeatedly used. When the outer tube is shortened by the repeated use, it is also possible to add a suitable piece to the outer tube by welding. When the inner tube is made of graphite or BN, and in addition, when the inner tube is tapered so as to become thin toward the bottom thereof, the crystal is easily released therefrom in almost cases. Thus, the inner tube can be reused intactly. If the crystals are not released from the inner tube, the latter is broken to take out the crystal therefrom. In this case, the inner tube is disposed of, which is nevertheless fairly economical, as compared with the breakage of the whole crucible. In such case for the easy removal of the crystals, it is recommended to notch the outer surface of the inner tube beforehand.

Furthermore, as shown in Fig. 2, the tip portion of the inner tube 3 may be formed into the shape of a thin pipe in order to enable accurate temperature control at this portion where initial crystallization occurs and in order to thereby smooth the crystal growth. In this case, the release of the crystals from the inner tube is difficult, and the crystals are liable to break in the thin pipe portion thereof, so that a part of the crystals often remains therein. However, when the next crystallization is carried out in the inner tube in which the crystals still remain partially in the thin pipe portion, the growth direction is stabilized, whereby the high-quality crystals can be obtained.

Example 1

By the use of a crucible having the structure shown in Fig. 1 and comprising an outer tube made of tungsten and an inner tube made of thermally decomposed graphite, single crystals of ZnSe (melting point = 1,520°C) were grown. This crystal growth was carried out by the following procedure: In the first place, the respective parts of the crucible were beforehand cleaned by burning them at about 1,700°C in vacuo prior to using any raw material. About 15 g of ZnSe (made by E. Merck AG) raw material powder was pressed/molded at 15 kg/cm$^3$ by a rubber press, and an inner tube was charged with the thus molded raw material and was then sealed with an inner lid. Afterward, the inner tube which was charged with the raw material was inserted into an outer tube and the latter was then sealed with an outer lid. The thus prepared crucible was then put in an electron beam welding device, and welding was carried out under a pressure of about 1.33 x 10$^{-3}$Pa (about 10$^{-5}$Torr) to seal the outer tube hermetically. In this case, the crucible was all cooled except the weld portion by a water cooling block made of copper so that the raw material therein might not vaporize. The crucible was then put in a vacuum furnace type Bridgman crystal growth device, and the maximum temperature was set to 1,580°C.

Crystal growth was then performed at a crucible descending speed of 2 mm/hr. After cooling, the upper portion of the crucible was cut off by a diamond cutter, and the inner tube was taken out therefrom. Formed crystals could be easily released from the inner tube made of thermally decomposed graphite. The crystals were transparent but assumed yellow, and any trace of the reaction of graphite with ZnSe was not observed. By analysis of ICP spectroscopy, no tungsten was detected in the crystals.

Example 2

To perform the crystal growth of GaAs (melting point = 1,237°C), the same procedure as in Example 1 was repeated with the exception that an outer tube made of tungsten and an inner tube made of pyrolytic BN were used, the maximum temperature was set to 1,290°C, and GaAs powder was used as a raw material. The formed crystals could be easily realised from the pyrolytic BN inner tube. The crystals had blueish metallic color, and the reaction of BN with GaAs was not observed. By the analysis of ICP spectroscopy, no tungsten was detected in the crystals.

Example 3

The single crystal growth of ZnSe was performed, using a crucible having the structure shown in Fig. 2 and comprising an outer tube made of molybdenum and an inner tube made of pyrolytic BN. This crystal growth was carried out by the following procedure: In the first place, the respective parts of the crucible were beforehand cleaned by burning them at about 1,700°C in vacuo prior to using the raw material. The inner tube was charged with about 15 g of ZnSe (Rare Metallic Inc.) crystalline chips (size = 1 mm x 1 mm), and the other steps were carried out in the same manner as in Example 1 in order to achieve the crystal growth. The formed crystals could be easily released from the inner tube made of pyrolytic BN, but in the thin pipe bottom portion of the inner tube, there remained a part of the crystals.

In succession, about 15 g of fine crystals which were a raw material were fed into the inner tube in which the crystals still remained in the thin pipe bottom portion. The upper portion of the molybdenum outer tube used in the above first crystal growth was reformed, and the empty outer tube was then burned at 1,700°C. After the inner tube was inserted into the outer tube, the crystal growth was performed in the same manner as in the above first step, and good crystals were then obtained in which a growth direction was the same as in the first step and in which the single crystals were present in a great region.

Comparative Example

The same procedure as in Example 1 was repeated with the exception that a crucible having the structure shown in Fig. 3 and made of tungsten was used, in order to achieve the single crystal growth of ZnSe. The resulting crystals could not be released from the crucible. For the release of the product therefrom, the crucible was required to be cut into several pieces by a diamond cutter. Furthermore, at this time, water used to wet the blade of the diamond cutter and cuttings of the tungsten adhered to the crystals.

**Claims**

1. A method for growing single crystals from a melt which comprises the steps of preparing a double structure crucible comprising an outer tube made of a weldable metal or alloy with a melting point of 1500°C or more and an inner tube made of one or more materials selected from metals and alloys with a melting point of 1500°C or more, ceramic materials with a melting point of 1500°C or more and carbon materials such as graphite; placing a raw material in the inner tube and then closing that tube; hermetically sealing the outer tube with an outer lid by welding; and then heating the raw material to melt it and to perform crystal growth.

2. A method as claimed in claim 1 in which the inner tube is made of graphite or a ceramic material having a melting point of 1500°C or more.

3. A method as claimed in claim 1 or claim 2 in which the inner tube is made of a ceramic material selected from aluminia, BN, AlN, BeO, MgO, SiC, SiO, $CeO_2$, $ThO_2$, $ZrO_2$ and $ZrSiO_4$.

4. A method as claimed in any one of claims 1 to 3 for growing crystals of ZnS, ZnSe, CdS, CdSe, GaP, GaAs, CdTe, HgS, PbSe or InP.

5. A method as claimed in any one of claims 1 to 4 in which the outer tube is made of W, Ta, Os, Mo, Ir, Ru, Rh, Pt or an alloy based on these metals.

6. A method as claimed in any one of claims 1 to 5 in which the welding is effected by means of an electron beam or laser beam.

7. A method as claimed in any one of claims 1 to 6 in which the tip portion of the inner tube is formed into the shape of a thin pipe to enable accurate temperature control in this region.

**Patentansprüche**

1. Ein Verfahren zum Züchten von Einkristallen aus einer Schmelze, das die Schritte umfaßt, daß ein doppelwandiger Schmelztiegel hergestellt wird, der ein äußeres Rohr, das aus einem schweißbaren Metall oder einer schweißbaren Legierung mit einem Schmelzpunkt von 1500°C oder höher hergestellt ist, und ein inneres Rohr, das aus einem oder mehreren Materialien hergestellt ist, die aus Metallen und Legierungen mit einem Schmelzpunkt von 1500°C oder höher, keramischen Materialien mit einem Schmelzpunkt von 1500°C oder höher und Kohlenstoffmaterialien wie Graphit ausgewählt sind, umfaßt; ein Rohmaterial in das innere Rohr eingebracht und dann das Rohr verschlossen wird; das äußere Rohr mit einem äußeren Deckel durch Schweißen hermetisch verschlossen wird und dann das Rohmaterial erhitzt wird, um es zu schmelzen und das Kristallwachstum durchzuführen.

2. Ein Verfahren nach Anspruch 1, bei dem das innere Rohr aus Graphit oder einem keramischen Material mit einem Schmelzpunkt von 1500°C oder höher hergestellt ist.

3. Ein Verfahren nach Anspruch 1 oder Anspruch 2, bei dem das innere Rohr aus einem keramischen Material hergestellt ist, das aus Aluminiumoxid, BN, AlN, BeO, MgO, SiC, SiO, $CeO_2$, $ThO_2$, $ZrO_2$ und $ZrSiO_4$ ausgewählt ist.

4. Ein Verfahren nach einem der Ansprüche 1 bis 3 zum Züchten von Kristallen aus ZnS, ZnSe, CdS, CdSe, GaP, GaAs, CdTe, HgS, PbSe oder InP.

5. Ein Verfahren nach einem der Ansprüche 1 bis 4, bei dem das äußere Rohr aus W, Ta, Os, Mo, Ir, Ru, Rh, Pt oder einer Legierung auf der Basis dieser Metalle hergestellt ist.

6. Ein Verfahren nach einem der Ansprüche 1 bis 5, bei dem das Schweißen mittels eines Elektronenstrahls oder eines Laserstrahls durchgeführt wird.

7. Ein Verfahren nach einem der Ansprüche 1 bis 6, bei dem der Spitzenbereich des inneren Rohres in der Form eines dünnen Rohres ausgebildet ist, um genaue Temperatursteuerung in diesem Bereich zu ermöglichen.

**Revendications**

1. Un procédé de croissance de monocristaux à partir d'une masse fondue comprenant les étapes de préparation d'un creuset à structure double comprenant un tube extérieur fait d'un métal ou alliage soudables ayant un point de fusion de 1 500°C ou plus et d'un tube intérieur fait d'une ou de plusieurs matières choisies parmi les métaux et alliages ayant un point de fusion de 1 500°C ou plus, les matières céramiques ayant un point de fusion de 1 500°C ou plus et les matières carbonées telles que le graphite ; mise en place d'une matière première dans le tube intérieur, puis fermeture de ce tube ; fermeture hermétique du tube extérieur avec un couvercle extérieur par soudage ; puis chauffage de la matière première pour la fondre et effectuer la croissance cristalline.

2. Un procédé selon la revendication 1, dans lequel le tube intérieur est fait de graphite ou d'une matière céramique ayant un point de fusion de 1 500°C ou plus.

3. Un procédé selon la revendication 1 ou la revendication 2, dans lequel le tube intérieur est fait d'une matière céramique choisie parmi l'alumine, BN, AlN, BeO, MgO, SiC, SiO, $CeO_2$, $ThO_2$, $ZrO_2$ et $ZrSiO_4$.

4. Un procédé selon l'une quelconque des revendications 1 à 3 pour la croissance de cristaux de ZnS, ZnSe, CdS, CdSe, GaP, GaAs, CdTe, HgS, PbSe ou InP.

5. Un procédé selon l'une quelconque des revendications 1 à 4, dans lequel le tube extérieur est fait de W, Ta, Os, Mo, Ir, Ru, Rh, Pt ou d'un alliage à base de ces métaux.

6. Un procédé selon l'une quelconque des revendications 1 à 5, dans lequel le soudage est effectué à l'aide d'un faisceau d'électrons ou d'un faisceau laser.

7. Un procédé selon l'une quelconque des revendications 1 à 6, dans lequel l'extrémité du tube intérieur a la forme d'un tube mince pour permettre une régulation précise de la température dans cette région.

FIG.1 FIG.2 FIG.3